# EUROPEAN PATENT APPLICATION

(11) **EP 1 862 824 A1**
(43) Date of publication of application: **05.12.2007**
(21) Application number: 06360020.9
(22) Date of filing: 29.05.2006
(51) Int. Cl.: G01V 3/10, H03K 17/95

(54) **Temperature compensated circuit and inductive sensor comprising said circuit**

(71) Applicant: Senstronic (Société Anonyme), 67700 Saverne (FR)
(72) Inventor: Kirchdoerffer, Rémy, CH-1134 Vufflens le Chateau (CH); Frolov, Vladimir, 67100 Strasbourg (FR)
(74) Representative: Nuss, Pierre

(57) **Abstract**

The present invention concerns a temperature compensated circuit and an inductive sensor comprising said circuit.

Temperature compensated circuit forming the sensitive element of an inductive sensor, said circuit comprising at least an inductance coil with two, first and second, parallel equivalent windings reeled around the same ferromagnetic core, first ends or starts of the first and second windings being connected to each other and to an output or terminal of the circuit.

Circuit (1) characterised in that one of said first and second windings (3, 3') is connected in series, with its end (5") opposite its first end or start (5, 5'), to a third winding (6) so as to form with said first and second windings (3 and 3') a pair of parallel unequal equivalent coils (3+6 and 3' ; 3'+6 and 3), said third winding (6) being also connected, directly or through a given resistance (7), with its end (6') not connected to said first or second windings (3, 3'), to the ground (G) or to an other output or terminal (B) of the circuit (1), said third winding (6) forming a boost current source proportional to the voltage between the two outputs or terminals (A and B) or between the output or terminal (A) and the ground (G).

## Description

The present invention concerns the field of electromagnetic based detection and sensing, in particular in an industrial environment, and relates particularly to an inductive proximity sensor or switch.

More specifically, the present invention concerns preferably an inductive sensor of the type generally comprising:
- an inductive coil defining a front working plane of the sensor and associated with a covering plate or a plane part of a housing, said plate or part being disposed perpendicularly to the coil axis and parallel to its front working plane,
- means for supplying the coil or inductance repeatedly with current,
- means for processing signals which correspond to the voltages induced in said coil or inductance when fed, said induced voltages being influenced by the presence of objects or bodies made of or with conductive material within a given detection area.

Inductive proximity sensors using coils as their sensitive elements are already known. The working principals of this type of sensors are as follows.

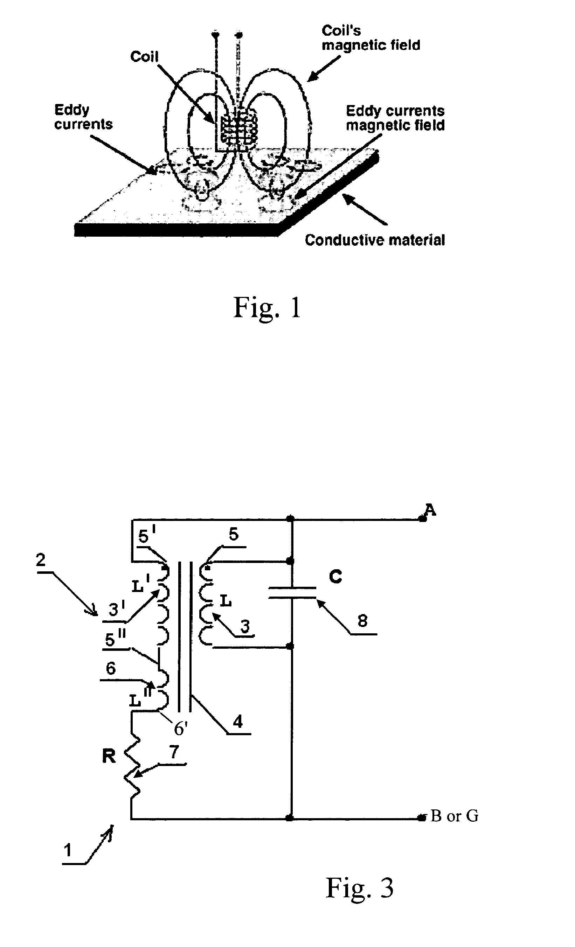

When the coil with its associated flux field is placed close to a conductive target, the field induces or establishes electric currents in the target. These currents are eddy currents, i.e. closed loops of induced current circulating (in a direction opposite the current in the coil) in planes perpendicular to the magnetic flux and generating their own magnetic field. Eddy currents normally travel parallel to the coil windings and to the target surface. The eddy current flow is limited to the area in the target laying within the inducing magnetic field (see figure 1).

The magnetic flux associated with the eddy currents opposes the coil's own magnetic flux. Decreasing the target-to-coil gap changes the coil's inductance and thus the net flux of the system. The result is a change in the coil impedance and a voltage change across the coil. It is this interaction between the coil and the eddy current fields that is the basis for determining target-to-coil position information with an eddy current position or detection sensor.

The most common method consists in constructing an active LC oscillator, which mode of operation depends on the inductance coil Q-factor. With target approaching, the Q-factor of the circuit, including the inductance or coil, decreases and the generation of oscillations stops. Such inductive sensors are described, for example, in DE 2 827 951 and US 4 879 531.

A second type of existing sensors works on a principle according to which an inductance coil is charged with a current of fixed value and then discharged through a standard resistance. The voltage level at the standard resistance, depending on parameters of the combined coil-target system, is used as a signal carrying information concerning the target proximity value. EP 0 492 029 and RU 2 072 523 describe sensors working according to this second principle.

In sensors of a third type, a capacitor is charged up to a determined voltage and then discharged through a corresponding coil. In this LC oscillating circuit, damped sinusoidal oscillations occur, the oscillations amplitude depending on the coil-target system parameters, i.e. the value of the target distance to the sensor. US-A-4 893 076 and US 2003/206007 describe sensors working according to this third principle.

A common problem for all types of induction sensors or analogy devices is a considerable dependence of the parameters of the inductance coil parameters from temperature, as with the temperature rising the resistance of the wire, reeled up to form the coil, increases. This increase in resistance leads to losses in the Q-factor, which effect can, in absolute value, exceed several times the effect of approach of the target.

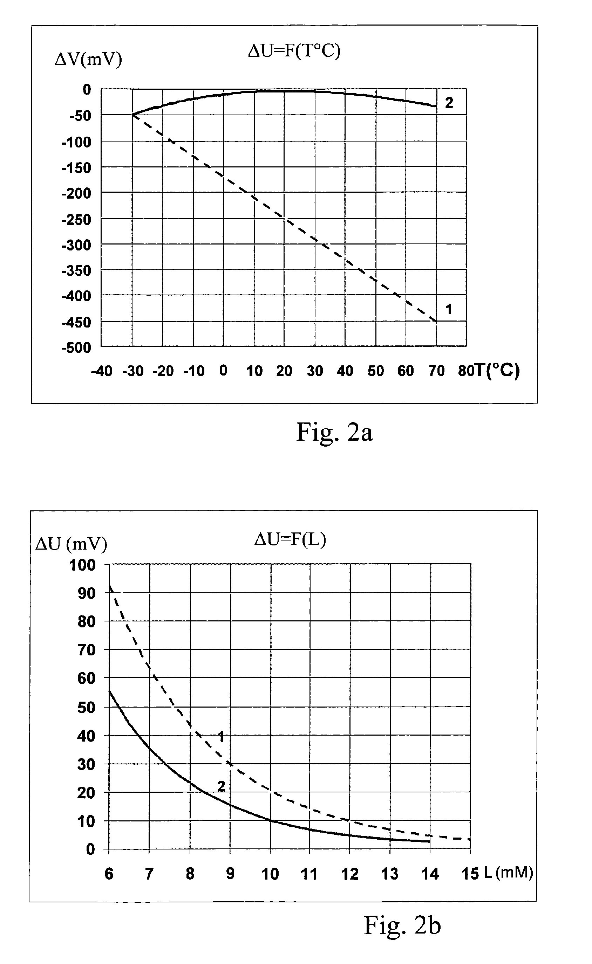

For example, in figures 2 are shown experimental dependencies of signal variation from temperature (figure 2a: signal amplitude vs. temperature) and from target approaching (figure 2b: signal amplitude vs. distance L between target and working plane).

The dependency curves references with "1" on figures 2a and 2b have been made using an LC oscillatory circuit as a converter of the target distance into voltage level. A 22nf condenser was charged to a voltage of 5 V and then discharged through an inductance coil containing 120 turns of wire having a diameter of 0,15 mm. The coil was placed in the cup ferrite core referenced SCH14/F08 and manufactured by NEOSOID company. The amplitude was measured at the 3^{rd} successive maximum of the damped oscillating process generated in the LC oscillatory circuit. As can be seen from these diagrams, the target effect at a distance of 10 mm corresponds to 20 mv in output signal variation or level, whereas the temperature drift of the signal level is 400 mv, i.e. the effect of the temperature drift exceeds 20 times the friendly or useful signal.

With US 4 509 023, a method of temperature stabilization of inductance coil parameters is disclosed.

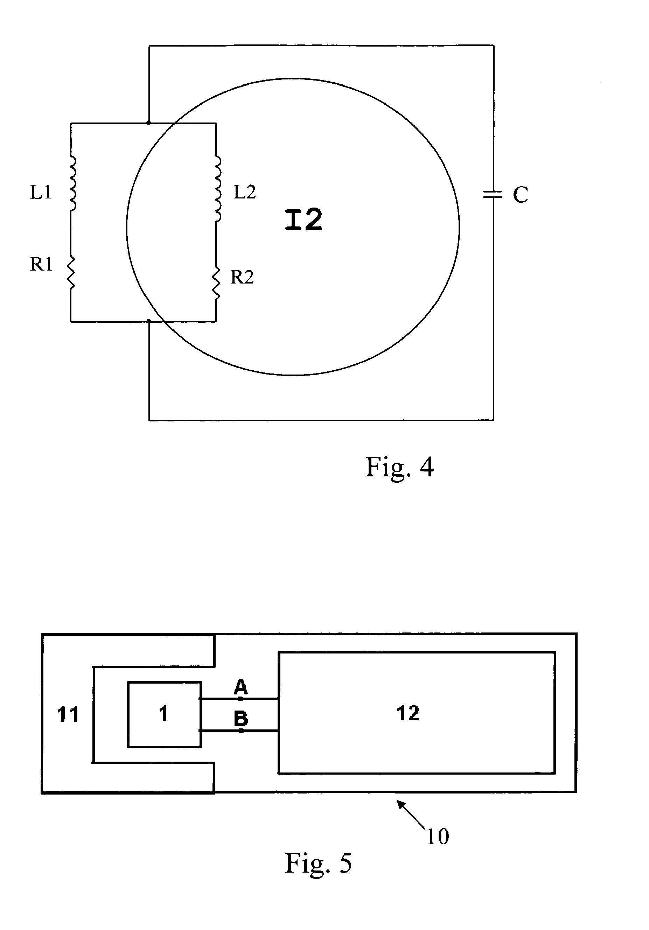

As indicated on figure 4 of said US document, there is provided a constant alternating current source I_{B} which injects a voltage U_{B} = I_{B} x R_{cu} (R_{cu} being the copper resistance of the coil) into the concerned oscillating circuit, the instantaneous values of which are proportional to the voltage at the oscillatory circuit U(T). Due to this, low outputs of the L and L' windings appear under various potentials and, as these windings have an equal number of turns, the mutual induction between said two winding tends to equalize potentials due to circulating currents running through the L and L' windings. The availability of circulating current shall reduce the circuit Q-factor. When the temperature increases, the winding resistance increases and the compensation effect is reached at lesser values of the current. Therefore, when the temperature increases, the loss for compensation drops, which compensates the loss increase in the LC oscillator circuit. The disadvantage of the solution proposed in US 4 509 023 consists in the necessity to use a special electronic circuit and corresponding adjustment components (for example, in the embodiment illustrated on figure 5 of said US document, two trimming elements - potentiometer P and "Driving blade" - are provided), which makes it non-technological, complicated and expensive.

The aim of the invention is to provide a solution for effective temperature compensation of a sensor with an inductive coil as the sensitive component, which is inexpensive, easy to realize and which does not require several additional trimming devices or components.

To achieve this aim, the present invention proposes a temperature compensated circuit forming the sensitive element of an inductive sensor, said circuit comprising at least an inductance coil with two, first and second, parallel equivalent windings reeled around the same ferromagnetic core, first ends or starts of the first and second windings being connected to each other and to an output or terminal of the circuit, circuit characterised in that one of said first and second windings is connected in series, with its end opposite its first end or start, to a third winding so as to form with said first and second windings a pair of parallel unequal equivalent coils, said third winding being also connected, directly or through a given resistance, with its end not connected to said first or second windings, to the ground or to an other output or terminal of the circuit, said third winding forming a boost current source proportional to the voltage between the two outputs or terminals or between the output or terminal and the ground.

It is also proposed an inductive presence or proximity sensor device of the aforementioned type, incorporating such a temperature compensated circuit.

The invention will be better understood thanks to the following description and drawings of embodiments of said invention given as non limitative examples thereof.

In the accompanying drawings:
Figure 3 is a schematical diagram of an embodiment of the temperature compensated circuit according to the invention in the form of an LC circuit;
Figure 4 is an equivalent circuit diagram of the LC circuit of figure 1 (without additional resistance R), and
Figure 5 is a schematical sectional view of an embodiment of an inductive sensor incorporating a temperature compensated sensitive circuit according to the invention.

Figure 3 shows a temperature compensated circuit 1 forming the sensitive element of an inductive sensor, said circuit comprising at least an inductance coil 2 with two, first and second, parallel equivalent windings 3 and 3' reeled around the same ferromagnetic core 4, first ends or starts 4 and 4' of the first and second windings 3 and 3' being connected to each other and to an output or terminal A of the circuit 1.

According to the invention, one of said first and second windings 3, 3' is connected in series, with its end 5" opposite its first end or start 5, 5', to a third winding 6 so as to form with said first and second windings 3 and 3' a pair of parallel unequal equivalent coils [3 + 6 and 3'] or [3' + 6 and 3], said third winding 6 being also connected, directly or through a given resistance 7, with its end 6' not connected to said first or second windings 3, 3', to the ground G or to an other output or terminal B of the circuit 1, said third winding 6 forming a boost current source proportional to the voltage between the two outputs or terminals A and B or between the output or terminal A and the ground G.

In accordance with a first practical embodiment of the invention, the inductance coil 2 has a transformer like structure, the third winding 6 consisting of additional turns of the wire forming the first or the second winding 3, 3' which are reeled on the common core 4.

In accordance with a second practical embodiment of the invention, the inductance coil 2 is a single winded coil of multiple conductor wire, at least one conductor of said wire being separated from the others at one end of the coil 2 and prolonged by additional turns forming the third winding 6 which are reeled on the common core 4.

In order to achieve an extremely precise temperature compensation, the third winding 6 can be connected to the ground G or to the other output or terminal B through a resistance 7 whose resistive value R equals a fraction of the resistive value of one turn of said third winding 6.

As shown on figure 3, the inductance coil 2 is preferably connected in parallel to a capacitor 8, which shunts the first winding 3 which is not connected in series with the third winding 6.

Thus, it is suggested to generate a boost source proportional to the oscillator circuit voltage at the expense of additional winding 6 or L", the voltage at said additional winding being generated at the expense of the coupling with winding 3 or L. Due to this, in the circuit formed by the elements L", L', L, and possibly R, a circulating current is generated, the value of which drops with the increase of temperature and winding resistance, respectively. The loss drops through the circulating current, respectively, and compensates the increase of the LC circuit loss. A Resistance R can be present for precise adapting of temperature compensation. The necessity of such an additional resistance can appear when precise adapting is required, as the possible quantity of turns in windings is discrete.

The working principles of the inventive thermocompensation will now be explained in connection with figure 4, corresponding to an equivalent representation of an exemplary embodiment of the concerned circuit.

The summary resistance of the inductive system or circuit increases with temperature and the heat losses in the LC-circuit because of the current 12, which leaks through the summary resistance, are increased accordingly. On the other hand, the Q-factor decreases correspondingly.

When compared with the circuit of figure 3, one can notice that (L1, R1) correspond to windings L' + L" and that (L2, R2) correspond to winding L, no additional resistance R being present (R1 and R2 corresponding to the internal resistance of the two equivalent coils).

Coils L1 and L2 have different quantity of spires (N1 < N2) and are placed on the same ferrite core. In such a configuration, there exists a current 11 and the heat losses of this current are equal to ΔU²/R3, where R3 = R1 + R2 (total resistance of the coils) and ΔU is the voltage on the "complementary" N2-N1 spires or turns of the coil L2. These losses lead to a certain decrease of the Q-factor of the circuit at T0, but at higher temperatures they become smaller (because of the increasing of R3), thus partially compensating the decrease of the Q-factor value of the system or circuit.

The selection of the appropriate number of "complementary" turns to achieve adjusted thermocompensation can be done experimentally or by approximation using preliminary calibration data or curves.

The curves referenced "2" on the figures 2a and 2b of the drawings represent the dependencies of the signal level variations from temperature (figure 2a) and from an approaching target (figure 2b) obtained with a inductive coil design according to the invention.

The inductance coil was placed, as for the reference coil (producing the curves referenced "1"), in a SCH14/F08 type ferrite cup.

All the windings of the inductance coil 2 according to the invention, were reeled with varnish insulated wire having a diameter of 0,1 mm. The L and L' windings contained 120 wire turns each and the L" coil was formed with 9 turns. As before, the amplitude was measured on the 3^{rd} successive maximum of the damped oscillating process generated in the LC oscillatory circuit.

As can be seen from the figures 2a and 2b, the effect of the target at a distance of 10 mm produces a signal amplitude of 20 mv, while the temperature drift of the signal level decreases up to 50 mv. Thus, in comparison with the base version of the coil design (curves 1), the inventive coil design (curves 2) provides a ratio of the friendly signal variation (from the target approaching at a distance of 10 mm) to the value of temperature drift which is improved by a factor of four. At shorter distances, the gain increases even more, as with a decrease in the distance, curves 1 and 2, shown in figure 2a, join together.

As shown through a non limitative example on figure 5, the present invention also encompasses an inductive presence or proximity sensor device 10, comprising a sensitive element 1 located in a detection head 11 having an active or sensitive plane or surface, said sensitive element 1 being connected by at least one output or terminal to a supply and signal acquisition circuit or unit 12, preferably associated with or linked to a control and signal processing module or unit (not shown). This sensor device 10 is characterised in that the sensitive element consists in a temperature compensated circuit 1 as described before.

As can be noticed from the foregoing, the advantageous effect of the invention can be obtained by simple means, as the manufacturing of an inductance coil 2 comprising two windings L' + L" and L with different number of turns reeled on the same core does not imply any technological difficulty.

The inductance coil design proposed by the invention allows to decrease the dependency of the inductance coil loss from temperature (and so allows to increase the operative distance of the sensor) and can be used in inductive sensors operating on the basis of various principles of conversion.

The present invention is, of course, not limited to the preferred embodiments described and represented herein, changes can be made or equivalents used without departing from the scope of the invention.

## Claims

1. Temperature compensated circuit forming the sensitive element of an inductive sensor, said circuit comprising at least an inductance coil with two, first and second, parallel equivalent windings reeled around the same ferromagnetic core, first ends or starts of the first and second windings being connected to each other and to an output or terminal of the circuit, circuit (1) **characterised in that** one of said first and second windings (3, 3') is connected in series, with its end 5" opposite its first end or start (5, 5'), to a third winding (6) so as to form with said first and second windings (3 and 3') a pair of parallel unequal equivalent coils (3+6 and 3' ; 3'+6 and 3), said third winding (6) being also connected, directly or through a given resistance (7), with its end (6') not connected to said first or second windings (3, 3'), to the ground (G) or to an other output or terminal (B) of the circuit (1), said third winding (6) forming a boost current source proportional to the voltage between the two outputs or terminals (A and B) or between the output or terminal (A) and the ground (G).

2. Circuit according to claim 1, **characterised in that** the inductance coil (2) has a transformer like structure, the third winding (6) consisting of additional turns of the wire forming the first or the second winding (3, 3'), which are also reeled on the common core (4).

3. Circuit according to claim 1, **characterised in that** the inductance coil (2) is a single winded coil of multiple conductor wire, at least one conductor of said wire being separated from the others at one end of the coil (2) and prolonged by additional turns forming the third winding (6), which are reeled on the common core (4).

4. Circuit according to anyone of claims 1 to 3, **characterised in that** the third winding (6) is connected to the ground (G) or to the other output or terminal (B) through a resistance (7) whose resistive value (R) equals a fraction of the resistive value of one turn of said third winding (6).

5. Circuit according to anyone of claims 1 to 4, **characterised in that** the inductance coil (2) is connected in parallel to a capacitor (8), which shunts the first winding (3) which is not connected in series with the third winding (6).

6. Inductive presence or proximity sensor device, comprising a sensitive element located in a detection head having an active or sensitive plane or surface, said sensitive element being connected by at least one output or terminal to a supply and signal acquisition circuit or unit, preferably associated with or linked to a control and signal processing module or unit, sensor device (10) **characterised in that** the sensitive element consists in a temperature compensated circuit (1) according to anyone of claims 1 to 5.
